# EUROPÄISCHE PATENTSCHRIFT

(11) **EP 0 519 215 B1**
(45) Veröffentlichungstag und Bekanntmachung des Hinweises auf die Patenterteilung: **30.08.1995**
(21) Anmeldenummer: 92108194.9
(22) Anmeldetag: 15.05.1992
(51) Int. Cl.: C03C 17/00, C23C 16/50, C23C 16/44, C03C 17/34

(54) **Vorrichtung und Anlage zum Beschichten von kalottenförmigen Substraten**
Device and installation for coating dome-shaped substrates
Dispositif et installation pour le revêtement de substrats sous la forme de calotte

(30) Priorität: 19.06.1991 DE 4120176
(43) Veröffentlichungstag der Anmeldung: 23.12.1992
(73) Patentinhaber: Schott Glaswerke, 55122 Mainz (DE); Carl-Zeiss-Stiftung trading as SCHOTT GLASWERKE, 55122 Mainz (DE)
(72) Erfinder: Etzkorn, Heinz-Werner, W-6392 Neu-Ansbach (DE); Krümmel, Harald, W-6500 Mainz 25 (DE); Weidmann, Günter, W-6509 Armsheim (DE); Paquet, Volker, W-6500 Mainz 21 (DE)
(74) Vertreter: Fuchs Mehler Weiss

(56) Entgegenhaltungen:
- DE-A- 4 008 405
- US-A- 3 731 650
- US-A- 3 926 508

## Beschreibung

Die Erfindung betrifft eine Vorrichtung zum Beschichten der Innenfläche von kalottenförmigen Substraten mit einem dielektrischen Schichtsystem, insbesondere von Reflektoren mit einer Kaltlichtspiegelbeschichtung, mit einer Beschichtungskammer, die durch das kalottenförmige Substrat und ein mit diesem an den Rändern zusammengesetztes und gasdicht verbundenes Rezipiententeil begrenzt ist, in dem ein Gaseinlaßkanal und ein Gasauslaßkanal mündet und das einen, einen oder mehrere Kanäle aufweisenden Verdrängungskörper zur Begrenzung der zu reagierenden Gasschicht aufweist, sowie mit Mitteln zur Anregung einer Plasmazone in der zu reagierenden Gasschicht. Die Erfindung bezieht sich auch auf eine Anlage zum Beschichten von kalottenförmigen Substraten, bei der mehrere Kalottenbeschichtungsstationen nebeneinander angeordnet sind.

Derartige Beschichtungsvorrichtungen sind aus der DE-C 4008405 (veröffentlicht am 11.7.91) und der EP-A-446 596 (veröffentlicht am 18.9.91) bekannt. Mehrere Kalotten sind zur Beschichtung mit einem Plasmaimpulsverfahren auf einer Bodenplatte eines Rezipienten in einem Raster nebeneinander angeordnet. Um das Reaktionsvolumen möglichst klein zu halten, sind die Kalotten in entsprechende Vertiefungen in der Bodenplatte eingesenkt. Die Deckplatte des Rezipienten ist entsprechend der Anordnung der Vertiefungen in der Bodenplatte mit einer Anordnung von Verdrängungskörpern versehen, welche in die von den zu beschichtenden Kalotteninnenflächen begrenzten Hohlräume eintauchen. In den Seitenwänden des Rezipienten sind mehrere Gasauslaßöffnungen vorgesehen, durch welche die an Schichtmaterial verarmten Reaktionsgase mittels einer Vakuumpumpe abgesaugt werden können. Diese Vorrichtung hat den Nachteil, daß die Gasströmung innerhalb des Rezipienten zum einen für jede Kalotte unsymmetrisch und zum anderen von Kalotte zu Kalotte unterschiedlich ist, sodaß je nach Lage der Kalotte innerhalb des Rezipienten die Beschichtung unterschiedlich ausfallen kann. Da die Fertigungstoleranzen eine exakte Anpassung der Vertiefung an die Kalottenform nicht zulassen, liegen die Kalotten nicht vollständig auf und es bildet sich zwischen der Außenseite der Kalotte und der Vertiefung ein Zwischenraum, in dem angeregte Spezies eine Beschichtung der Kalottenaußenwand bewirken können.

Um diesen unerwünschten Effekt zu beseitigen wurde in der DE-C-4008405 eine weitere Ausführung vorgeschlagen, wobei die zu beschichtende Kalotte mit einem halbseitig offenen Gefäß zu einem Rezipienten zusammengefügt wurde. Zwar wird mit einer derartigen Vorrichtung die unerwünschte Abscheidung der Reaktionsgase auf der Außenfläche der Kalotte vermieden, jedoch wird keine völlig symmetrische Gasführung im Bereich der Kalotte wegen des Gasauslaßrohres erreicht. Ein weiterer Nachteil dieser Vorrichtung besteht darin, daß nur einzelne Kalotten nacheinander beschichtet werden können. Wenn mehrere derartiger Vorrichtungen betrieben werden, so sind diese mit einem eigenen Gaserzeuger und eigener Mikrowelleneinrichtung zur Erzeugung des Plasmas ausgerüstet. Die Anlage- und Betriebskosten sind bei einer solchen Addition von Einzelbeschichtungsanlagen sehr hoch.

Aufgabe der Erfindung ist es daher, eine Vorrichtung und eine Anlage bereitzustellen, mit der mehrere Kalotten gleichzeitig auf kostengünstige Weise mit gleicher und hoher Qualität beschichtet werden können.

Diese Aufgabe wird mit einer Vorrichtung gemäß Anspruch 1 und einer Anlage gemäß Anspruch 19 gelöst. Vorteilhafte Ausgestaltungen sind Gegenstand der Unteransprüche.

Erfindungsgemäß werden mindestens zwei Beschichtungskammern unter Ausbildung einer Kalottenbeschichtungsstation nebeneinander angeordnet, die an einen für alle Beschichtungskammern gemeinsamen Gaserzeuger und an eine gemeinsame Vakuumpumpe mittels Gasleitungen angeschlossen ist, wobei die Gasleitungen für die Gaszufuhr als auch die Gasleitungen für die Gasabfuhr jeweils ein symmetrisches Gasleitungssystem bilden. Sowohl die Querschnittsfläche Q_{A}(x) als auch die Querschnittsform Q_{F}(x) der Gasleitungen sind in Abhängigkeit von der Entfernung x vom Gaserzeuger bzw. von der Vakuumpumpe im wesentlichen gleich. Unter der Entfernung x wird eine Strecke längs der Gasleitungen vom Gaserzeuger zum Ort x verstanden. Durch das Vorsehen dieser Maßnahmen werden in den einzelnen Beschichtungskammern weitgehend identische Strömungsverhältnisse erzielt, so daß die Beschichtung der in den Kalottenbeschichtungsstationen beschichteten Substrate eine gleich hohe Qualität aufweist. In jeder Beschichtungskammer fließt ein Gasmassenfluß, der sich um höchstens ± 3 % vom Mittelwert des Gesamtmassenflusses geteilt durch die Zahl der Beschichtungskammern unterscheidet.

Ein weiterer Vorteil besteht darin, daß nicht für jede Beschichtungskammer eigene Massenflußregler vorzusehen sind, da nunmehr aufgrund des verzweigten symmetrischen Gasleitungssystems lediglich pro Gas ein Massenflußregler im Gaserzeuger ausreicht.

Gemäß einer Ausführungsform können die symmetrischen Gasleitungssysteme durch Präzisionsrohre gebildet werden, die bezüglich ihres Querschnittes geringe Toleranzen aufweisen.

Anstelle eines Rohrleitungssystems werden gemäß einer besonderen Ausführungsform in mindestens einer gemeinsamen massiven Platte die Gasleitungssysteme als Gaskanäle eingebracht. Die Rezipiententeile der einzelnen Beschichtungskammern sind als Ausnehmungen in dieser mindestens einen gemeinsamen Platte ausgebildet.

Die einzelnen zu beschichtenden Kalotten werden nicht mit ihrer Außenseite in diese Ausnehmungen gelegt, wie es beim Stand der Technik der Fall ist, sondern die Kalotten werden auf den Rand der Ausnehmungen gelegt, so daß die zu beschichtnde Innenseite der Kalotte der Ausnehmung gegenüberliegt. Auf diese Weise werden einzelne Beschichtungskammern in der gemeinsamen massiven Platte ausgebildet. Um einen dichten Abschluß der Beschichtungskammern zu gewährleisten, sind zwischen dem Rand der Ausnehmungen und der zu beschichtenden Kalotte mindestens ein Dichtelement angeordnet.

Vorzugsweise sind mindestens zwei massive Platten vorgesehen, die aufeinandergelegt sind, wobei in mindestens einer Platte die Ausnehmungen für die Ausbildung der Beschichtungskammern eingebracht sind. Zwischen den Platten sind Dichtungselemente angeordnet, die aus Dichtscheiben oder Dichtringen bestehen können. Anstelle von Dichtelementen kann jeweils mindestens eine der beiden Flächen der Platten mit einer Elastomerschicht versehen sein, wobei deren Dicke nach dem Grad der Ebenheit der Oberfläche einzustellen ist. Die Elastomerschicht wird vorzugsweise auf der Oberfläche der Platte oder Platten angebracht, in die keine Kanäle eingearbeitet sind.

Der Aufbau einer Kalottenbeschichtungsstation mit mehreren Platten ermöglicht es, die Gaskanäle für die einzelnen Beschichtungskammern ausschließlich durch Bohren und/oder Fräsen in die Oberflächen der Platten herzustellen. Die in die Oberfläche eingefrästen Kanäle werden durch die Nachbarplatte bzw. Dichtelement bzw. die Elastomerschicht der Nachbarplatte begrenzt. Die Ausbildung der Gaskanäle in den einzelnen Platten durch Bohren oder Fräsen bietet den Vorteil, daß eine hohe Packungsdichte der Zu- und Ableitungen, eine große Stabilität und eine einfache Reinigungsmöglichkeit des gesamten Leitungssystems erzielt wird. Ein weiterer Vorteil besteht darin, daß die Kanäle mit großer Präzision gefertigt werden können. Auf diese Weise wird ein weitgehend gleicher Strömungsleitwert für alle Kanäle erzielt mit dem Vorteil, daß ein zusätzlicher Abgleich, z.B. durch Blenden, zur gleichmäßigen Verteilung der Gase auf die Kanäle und Beschichtungskammern entbehrlich ist.

Die massiven Platten können aus Metall wie z.B. Aluminium, Edelstahl oder aus einem Kunststoff wie z.B. Teflon oder PVDF bestehen und sind bei Bedarf mit einem gegen die durchfließende Gasmischung resistenten Belag versehen. Die Dichtelemente bestehen vorzugsweise aus Silikongummi und weisen zumindest teilweise ein den in den Platten eingebrachten Durchgangsbohrungen angepaßte Aussparungen auf, um den Gasfluß von einer Platte zur anderen Platte zu ermöglichen. In den Bereichen, wo in den Oberflächen eingefräste Kanäle vorhanden sind, schließen die Dichtelemente bzw. die Elastomerbeschichtung diese Kanäle gegenüber der Nachbarplatte dichtend ab.

Vorzugsweise sind die Beschichtungskammern auf einem Kreis angeordnet, zu denen die Gaseinlaßkanäle und die Gasauslaßkanäle vom Zentrum der Kalottenbeschichtungsstation sternförmig hinführen. Das Zentrum ist jeweils mit einem Haupteinlaßkanal und einem Hauptauslaßkanal verbunden. Dadurch wird erreicht, daß auch der Strömungsweg zu den einzelnen Beschichtungskammern gleich lang und gleich geformt ist. Da das Reaktionsgas in der Regel aus zwei Komponenten besteht, wird auf diese Weise sichergestellt, daß die Vermischung der beiden Komponenten bei Erreichen der einzelnen Beschichtungskammern keine Unterschiede aufweist, die zu einer ungleichmäßigen Beschichtung der Kalotten führen könnte.

Gemäß einer bevorzugten Ausführungsform sind insgesamt vier Platten mit drei dazwischen gelegten Dichtscheiben für die Ausbildung einer vier Beschichtungskammern aufweisenden Kalottenbeschichtungsstation ausreichend. Die erste Platte, auf der die zu beschichtenden Kalotten mit ihrem Rand aufgelegt werden, besitzt ausschließlich Durchgangsbohrungen zur Ausbildung der Beschichtungskammern. Die zweite Platte kann mit den Durchgangsbohrungen der ersten Platte deckungsgleiche Sackbohrungen zur Vervollständigung der Beschichtungskammern aufweisen. Es besteht aber auch die Möglichkeit, auf diese Sackbohrungen zu verzichten, wobei dann die den Durchgangsbohrungen der ersten Platte zugeordneten Oberflächenbereiche der zweiten Platte den Boden der Beschichtungskammer bilden. In den Sackbohrungen bzw. in den Oberflächenbereichen, die den Bodenbereich der Beschichtungskammern bilden, sind weitere Durchgangsbohrungen zur Ausbildung jeweils eines Abschnittes der Gaseinlaßkanäle und der Gasauslaßkanäle vorgesehen. Die Abschnitte der Gaseinlaßkanäle stehen mit sternförmig in der Oberfläche dieser zweiten Platte eingebrachten Kanälen in Verbindung, wobei diese sternförmig angeordneten Kanäle in einen zentral angeordneten als Durchgangsbohrung ausgebildeten Abschnitt des Gaseinlaßkanals münden und in einen in der gegenüberliegenden Oberfläche der zweiten Platte eingebrachten Haupteinlaßkanal übergehen.

Die dritte Platte der Kalottenbeschichtungsstation besitzt mit dem Gasauslaßkanal der zweiten Platte deckungsgleiche Durchgangsbohrungen, die in jeweils sternförmig in der Oberfläche eingebrachte Gasauslaßabschnitte münden.

Die vierte Platte dient als Abschlußplatte und weist den gemeinsamen Haupteinlaßkanal und den gemeinsamen Hauptauslaßkanal auf, die an die gemeinsame Vakuumpumpe bzw. die gemeinsame Gasquelle angeschlossen sind.

Im allgemeinen werden die beiden Schichtmaterialien so ausgewählt, daß zu ihrer Herstellung im Plasma-CVD-Prozeß insbesondere PICVD-Verfahren, nur drei unterschiedliche Ausgangsgase zur Verfügung gestellt werden müssen. Bei diesen Gasen handelt es sich beispielsweise um O₂, das nachfolgend als Gas A bezeichnet werden soll, sowie um beispielsweise TiCl₄ oder OSi₂(CH₃)₆, die als Gase B und C bezeichnet werden und je nach gewünschter Beschichtung dem Gas A zugemischt werden. Bei der Ausbildung eines Schichtsystems in der Kalotte werden abwechselnd die Gaskombinationen A plus B und A plus C in die Beschichtungskammer geleitet.

Im Interesse einer kostengünstigen Beschichtung muß die Beschichtungsgeschwindigkeit hoch sein. Um dies zu erreichen, ist gemäß einer bevorzugten Ausführungsform eine Gasverteilungseinrichtung zwischen dem symmetrischen Gasleitungssystem und dem Gaserzeuger angeordnet. Diese Einrichtung weist eine Zuführleitung für das Gas A und zwei unabhängige Leitungen für die Gase B und C auf, die in die gemeinsame Zuleitung für das Gas A münden, wo dann die Durchmischung der beiden jeweiligen Gase stattfindet. In den Zuleitungen für die Gase A und B sind Absperrventile sowie jeweils eine Bypassleitung mit einem weiteren Absperrventil vorgesehen.

Wenn die Gaskombination A plus B gewünscht wird, wird die Gasleitung für das Gas C abgesperrt und das Gas C durch die offene Bypassleitung zur Pumpe geleitet. Wenn die Gaskombination A plus C gewünscht wird, werden entsprechend in der Gasleitung B die Ventile geschaltet und die Bypassleitung der Gasleitung C geschlossen und das entsprechende zweite Ventil geöffnet.

Als Ventile werden besonders schnelle Ventile eingesetzt, die mit Zeiten < 0,2 Sekunden geschaltet werden können. Durch die Umleitung des jeweils nicht gewünschten Gases in die Bypassleitung kann der Massenfluß aufrechterhalten werden. Es ist somit möglich, die im Gaserzeuger eingebauten Massenflußregler für die Gase A, B und C auf einen konstanten Sollwert einzustellen. Der Nachteil des jeweils zwischenzeitlich zu verwerfenden Gases wird dadurch kompensiert, daß ein rascher Wechsel ohne Zeitverluste möglich ist, sodaß nicht erst gewartet werden muß, bis der Gasmassenfluß sich wieder dem Sollwert genähert hat, wie es der Fall wäre, wenn der Gasmassenfluß unterbrochen werden würde.

Um die gleichmäßige Verteilung des Gases auch in den Beschichtungskammern zu gewährleisten und damit eine gleichbleibende Qualität der Beschichtung sicherzustellen, ist in den einzelnen Beschichtungskammern ein Düseneinsatz vorgesehen, auf dem der Verdrängungskörper befestigt ist. Dieser Düsenkörper besitzt vorzugsweise einen Gewindefortsatz, auf dem der Verdrängungskörper aufschraubbar ist, oder einen Konus, auf dem der Verdrängungskörper aufsteckbar ist. Dies bietet den Vorteil, daß der Verdrängungskörper in axialer Richtung zur Einstellung eines gewünschten Abstandes zur Innenfläche der zu beschichtenden Kalotte einstellbar ist. Der Düsenkörper ist vorzugsweise wie die gesamte Kalottenbeschichtungsstation ebenfalls aus mehreren aufeinandergelegten Platten sandwichartig aufgebaut. Hierbei sind die Kanäle in den Düsenplatten zur azimutalen Gasführung ausgebildet. Die Kanäle sind in diesen Düsenplatten ebenso wie in den Platten der Kalottenbeschichtungsstation durch Bohren und/oder Fräsen eingebracht, um eine hohe Genauigkeit der Gaskanäle zu erzielen. Dadurch wird sichergestellt, daß die Qualität der Strömungskanäle im Düsenkörper der der symmetrischen Gasleitungssysteme entspricht.

Eine besonders gute azimutale Gasführung wird erreicht, wenn in jeder Düsenplatte ein Ringkanal vorgesehen ist, der mit dem Ringkanal der jeweiligen Nachbarplatte über mehrere Verbindungskanäle, die in axialer Richtung angebracht sind, in Verbindung steht. Damit sich der von einer Düsenplatte in die nächste Düsenplatte strömende Gasfluß jeweils in zwei Ströme aufteilt, sind diese Verbindungskanäle benachbarter Platten versetzt zueinander angeordnet. Neben einer optimalen Gasverteilung in den Ringkanäle wird hierdurch auch eine Verbesserung der Durchmischung der Gaskomponenten erzielt.

Gemäß einer besonderen Ausführungsform nimmt die Anzahl der Verbindungskanäle von Düsenplatte zu Düsenplatte in Richtung zum kalottenförmigen Substrat zu. Der Querschnitt der Verbindungskanäle wird von Düsenplatte zu Düsenplatte kleiner, so daß eine homogene laminare Strömung in der Beschichtungsstation im Bereich der zu beschichtenden Kalottenfläche erzielt wird. Das an Reaktionsstoffen verarmte Gas wird dann durch den zentralen Kanal im Verdrängungskörper abgesaugt, der sich durch die Düsenplatten zum Gasauslaßkanal der jeweiligen Beschichtungskammer erstreckt.

Es besteht auch die Möglichkeit, das Gas durch den zentralen Kanal im Verdrängungskörper der Beschichtungskammer zuzuführen und das verbrauchte Reaktionsgas durch die Verbindungsbohrungen der oberen Düsenplatte in den darunterliegenden Kanal abzuführen und von dort in den Gasauslaßkanal der jeweiligen Beschichtungskammer zuzuführen.

Die Mittel zur Anregung einer Plasmazone in mehreren Beschichtungskammern bestehen zur Einsparung von Anlage- und Betriebskosten aus einer einzigen Mikrowelleneinrichtung, wobei vorzugsweise eine Mikrowelleneinrichtung zur Ausführung des PICVD-Verfahrens gewählt wird. Diese Mikrowelleneinrichtung umfaßt gemäß einer besonderen Ausführungsform ein für alle Beschichtungskammern einer Kalottenbeschichtungsstation gemeinsames Magnetron mit einem zugeordneten Impulsgeber.

Gemäß einer Ausführungsform ist über den Kalotten einer Kalottenbeschichtungsstation ein absenkbar Resonatorkasten mit einem mittig sitzenden Magnetron vorgesehen. Dieses Magnetron ist an den zugeordneten Impulsgeber angeschlossen.

Gemäß einer weiteren Ausführungsform ist über den kalottenförmigen Substraten ein auf die Kalottenbeschichtungsstation absenkbares Hohlleiterkreuz mit Metallrohren und Metallkoppelstiften vorgesehen, wobei das Hohlleiterkreuz über geeignete Verbindungsleiter an das gemeinsame Magnetron angeschlossen ist.

Es besteht auch die Möglichkeit, jede Beschichtungskammer individuell über ein Magnetron mit Mikrowellenenergie zu versorgen, wobei für jedes Magnetron entweder ein eigener oder für mehrere Magnetrons ein eigener Impulsgenerator vorgesehen ist, der die Hochspannungsimpulse liefert.

Der Durchsatz von zu beschichtenden Kalotten kann dadurch auf kostengünstige Weise erhöht werden, daß mehrere erfindungsgemäße Kalottenbeschichtungsstationen zu einer Beschichtungsanlage angeordnet werden. Die in einer Anlage zusammengefaßten Kalottenbeschichtungsstationen sind in diesem Fall an einen gemeinsamen Gaserzeuger bzw. eine gemeinsame Vakuumpumpe angeschlossen, sodaß die Kosten für die Gesamteinrichtungen deutlich gesenkt werden können. Die Gasleitungen zwischen dem Gaserzeuger bzw. der Vakuumpumpe und den einzelnen Kalottenbeschichtungsstationen sind in gleicher Weise ausgebildet wie in einer Kalottenbeschichtungsstation. Es sind symmetrische Gasleitungssysteme vorgesehen, wobei die Querschnittsfläche q_{A}(y) und die Querschnittsform q_{F}(y) der Gasleitungen in Abhängigkeit von der Entfernung y vom Gaserzeuger bzw. von der Vakuumpumpe im wesentlichen gleich mit.

Die Gasleitungen können ebenfalls aus Präzisionsrohren bestehen.

Gemäß einer bevorzugten Ausführungsform sind die Kalottenbeschichtungsstationen auf einer ein- oder mehrteiligen massiven Verteilerplatte nebeneinander angeordnet. Die mehrteilige Ausführung dieser Verteilerplatte bietet den Vorteil, das die Versorgungskanäle und Absaugkanäle ebenfalls ausschließlich durch Bohren und/oder Fräsen in der Oberfläche der Verteilerplatte hergestellt werden können. Somit wird auch in der Zuführung des Gases zu den einzelnen Kalottenbeschichtungsstationen der gleiche Standard gewährleistet, wie er in jeder Kalottenbeschichtungsstation und in den einzelnen Beschichtungskammern durch die erfindungsgemäße Ausgestaltung vorhanden ist.

Vorzugsweise werden die Kalottenbeschichtungsstationen zu zwei Gruppen zusammengefaßt, wobei jede Gruppe über eigene Versorgungskanäle mit dem Gaserzeuger verbunden ist. Da die aufzubringende Beschichtung aus einem Schichtsystem besteht, das abwechselnd aus der Gaskombination A plus B und der Gaskombination A plus C gebildet wird, sind in den Versorgungsleitungen Umschaltventile vorgesehen, die mit einer entsprechenden Steuereinrichtung verbunden sind, sodaß die Kalottenbeschichtungsgruppen abwechselnd mit den beiden gewünschten Gasgemischen versorgt werden können.

Der Gaserzeuger ist hierbei so ausgelegt, daß er gleichzeitig an die eine Kalottenbeschichtungsgruppe die Gasarten A und B und an die andere Kalottenbeschichtungsgruppe die Gasarten A und C liefern kann. Bei der Herstellung der beiden Interferenzschichtsysteme werden die Gase B und C in die jeweils andere Kalottenbeschichtungsgruppe umgeschaltet, wenn die entsprechenden Schichten gerade aufgebracht sind. Dauert die Herstellung der Schichten, für die die Gase B und C benötigt werden, unterschiedlich lange, dann wird das Gas, das gerade nicht benötigt wird, in eine Bypassleitung umgelenkt und in der entsprechenden Kalottenbeschichtungsgruppe zweckmäßigerweise ein Sauerstoffplasma brennen gelassen. Der Vorteil dieser Anlage besteht darin, daß bis zu 50 % der möglicherweise teuren Gase B und C eingespart werden können. Ein weiterer Vorteil besteht darin, daß keine Unterbrechung des Gasflußes vorgenommen werden muß, sodaß wiederum ein schnelles Umschalten und damit eine schnelle Beschichtung der Kalotten ermöglicht wird.

Es besteht aber auch die Möglichkeit, alle Kalottenbeschichtungsstationen jeweils mit dem gleichen Gasgemisch zu beschicken, wobei nach einer vorgesehenen Zeitspanne zur Herstellung einer Schicht auf die jeweils andere Gasmischung umgeschaltet wird. Hierzu ist eine Gasverteilungseinrichtung vorgesehen, die in der gleichen Weise arbeitet, wie die zuvor für eine Kalottenbeschichtungsstation beschriebene Gasverteilungseinrichtung.

Beispielhafte Ausgestaltungen der Erfindung werden nachfolgend anhand der Zeichnungen näher erläutert.

Es zeigen
- Figur 1: die schematische Darstellung einer Kalottenbeschichtungsstation
- Figur 2: die perspektivische Darstellung einer Kalottenbeschichtungsstation gemäß einer weiteren Ausführungsform
- Figur 3: die Gasversorgungseinrichtung einer Kalottenbeschichtungsstation in schematischer Darstellung
- Figuren 4 a bis 7 b: die die Kalottenbeschichtungsstation bildenden massiven Platten in Draufsicht und im Schnitt
- Figuren 8 a bis 11 b: den aus mehreren Düsenplatten bestehenden Düsenkörper in Draufsicht und im Schnitt
- Figuren 12 a und 12 b: einen Düsenkörper gemäß einer weiteren Ausführungsform
- Figur 13 a, 13 b: die Mikrowelleneinrichtung einer Kalottenbeschichtungsstation in Seitenansicht und Draufsicht
- Figur 14 a und 14 b: die Draufsicht bzw. den Schnitt einer Kalottenbeschichtungsanlage in schematischer Darstellung.

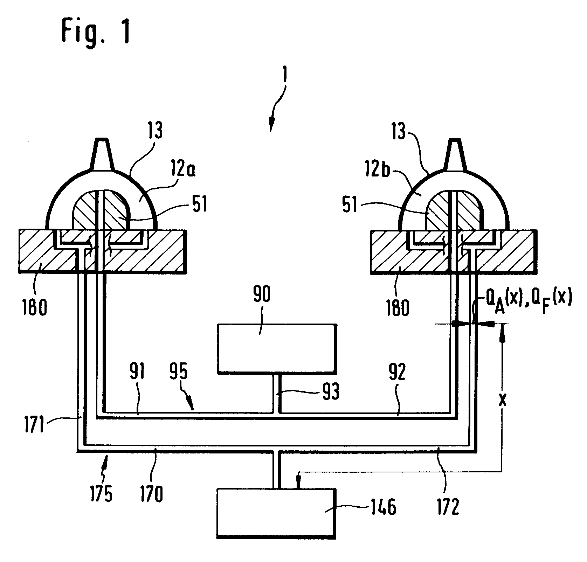

In der Figur 1 ist eine Kalottenbeschichtungsstation 1 schematisch dargestellt. Es sind zwei Beschichtungskammer 12 a und 12 b vorgesehen, die jeweils durch das kalottenförmige Substrat 13 und den Rezipiententeil 180 gebildet wird. Die kalottenförmige Substrate 13 liegen abdichtend auf den Rezipiententeilen 180 auf, die ein verzweigtes Gasleitungssystem aufweisen, daß anhand der nachfolgenden Figuren noch eingehend beschrieben wird.

In den Beschichtungskammer 12 a und 12 b sind Gasverdrängungskörper 51 angeordnet. Von einem Gaserzeuger 146, der auch die entsprechenden Massenflußregler aufweist, führt ein symmetrisches Gasleitungssystem 175 mit den Gasleitungen 170, 171 und 172 zu den einzelnen Rezipiententeilen 180. Zum Absaugen der verbrauchten Beschichtungsgase ist ebenfalls ein symmetrisches Gasleitungssystem 95 mit den Gasleitungen 91, 92 und 93 vorgesehen, die von den Rezipiententeilen 180 zu einer gemeinsamen Vakuumpumpe 90 führen. Der Querschnitt Q_{A}(x) und die Querschnittsform Q_{F}(x) ist für die Gasleitungen mit der gleichen Entfernung x vom Gaserzeuger zur Ausbildung gleicher Strömungsverhältnisse in den Beschichtungskammern 12 a und 12 b im wesentlichen gleich groß. Die Entfernung x ist in der Firgur 1 bezüglich der Gasleitung 170, 172 eingezeichnet.

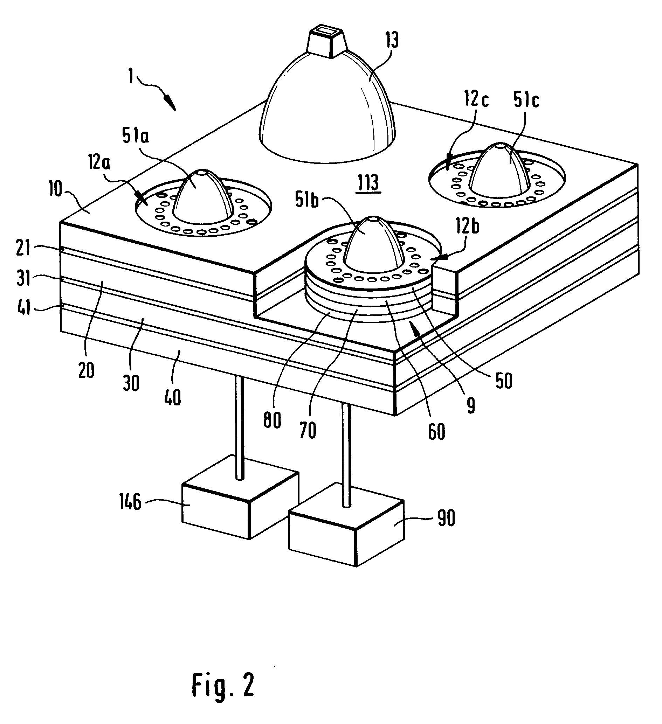

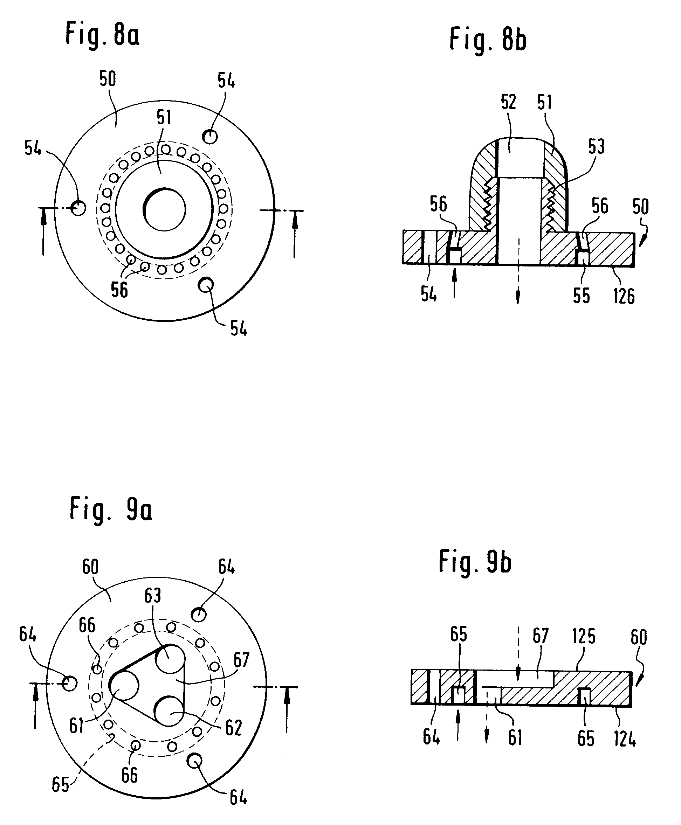

Die in der Figur 1 dargestellten symmetrischen Gasleitungssysteme 95 und 175 sind aus Präzisionsrohren gefertigt. Die Rezipiententeile 180 können durch den Düsenkörper 9 gebildet werden, wie er in der Figur 2 und den Figuren 8 a bis 11 b dargestellt ist.

In der Figur 2 ist eine Kalottenbeschichtungsstation 1 mit insgesamt vier Beschichtungskammern 12 a bis 12 d dargestellt, wobei die symmetrischen Gasleitungssysteme in vier massiven Platten 10, 20, 30, 40 eingebracht sind. Diese massiven Platten sind übereinandergelegt, wobei zwischen den massiven Platten 10, 20, 30 und 40 Dichtscheiben 21, 31 und 41 angeordnet sind, die auch als Elastomerbeschichtung auf den Platten 10, 20, 30 oder 40 ausgebildet sein können. Die Kalottenbeschichtungsstation 1 ist an eine gemeinsame Vakuumpumpe 90 und einen gemeinsamen Gaserzeuger 146 angeschlossen. Wie in der teilweise im Schnitt dargestellten rechten vorderen Beschichtungskammer 12 b zu sehen ist, ist die Platte 10 mit einer Durchgangsbohrung und die Platte 20 mit einer Sackbohrung zur Ausbildung der Beschichtungskammer 12 b versehen. Die Beschichtungskammer 12 a, 12 c und 12 d sind in der gleichen Weise ausgebildet. In jeder Beschichtungskammer 12 a bis 12 d ist ein Düsenkörper 9 angeordnet, der am oberen Ende jeweils einen Verdrängungskörper 51 a bis 51 d aufweist. Der Verdrängungskörper 51 d ist in der hier gezeigten Darstellung nicht zu sehen, da er von der eingezeichneten zu beschichtenden Kalotte 13 verdeckt ist.

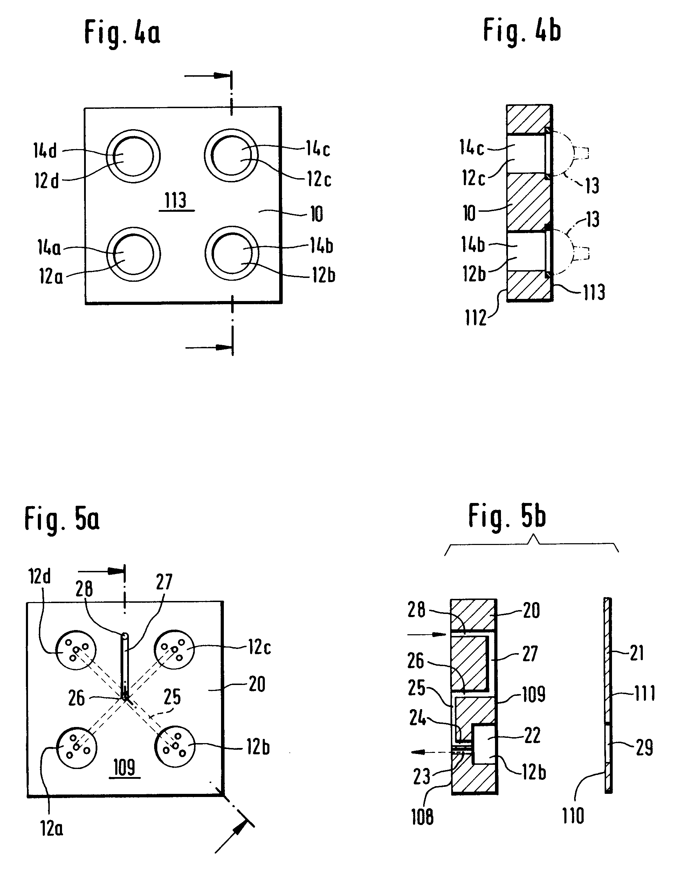

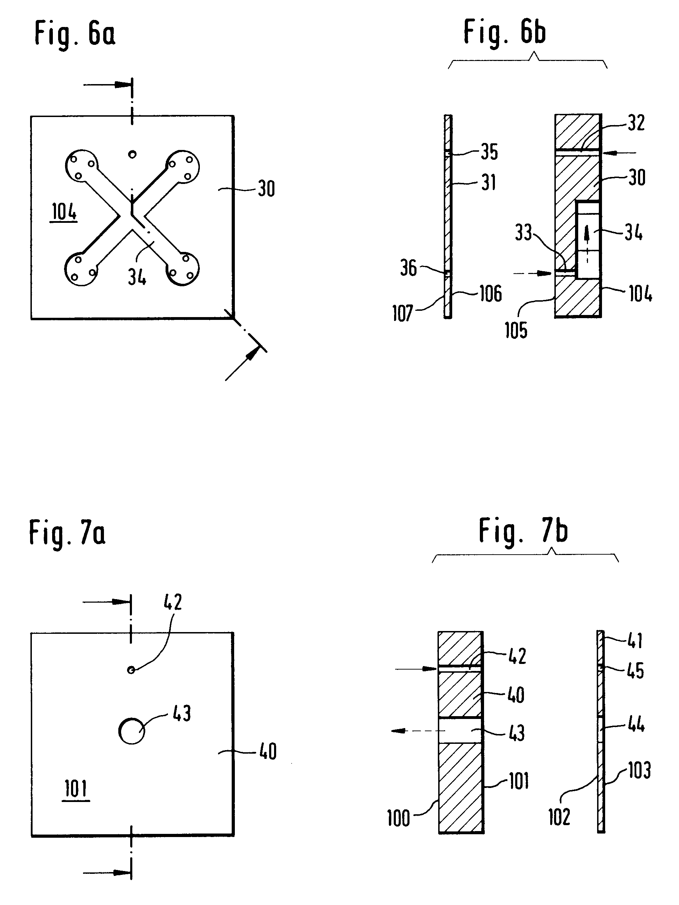

Die Ausgestaltung der Platten 10, 20, 30 und 40 ist in den Figuren 4 a bis 7 b dargestellt, während der Düsenkörper 9 Gegenstand der Figuren 8 a bis 11 b ist.

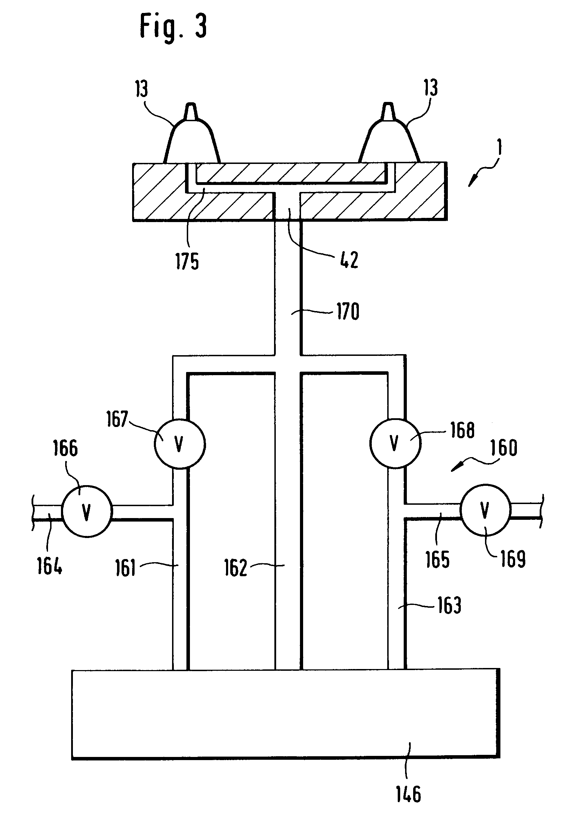

In der Figur 3 ist zwischen der Kalottenbeschichtungsstation 1 bzw. dem Gasleitungssystem 175 und dem Gaserzeuger 146 eine Gasverteilungseinrichtung 160 vorgesehen. Für die drei Gase A, B und C ist jeweils eine eigene Gasleitung 161, 162 und 163 vorgesehen, die in eine gemeinsame in den Gaseinlaßkanal 42 der Platte 40 mündende Gasleitung 170 zusammengeführt sind. Da das Gas A immer in Kombination mit dem Gas B bzw. mit dem Gas C eingesetzt wird, strömt das Gas A ständig durch die Gasleitung 162, während die Gase B und C durch die absperrbaren Leitungen 161 und 163 geleitet werden. Um die Gase B und C jeweils dem Gas A zumischen zu können, sind schnellschaltende Ventile 166, 167, 168 und 169 vorgesehen, wobei die Ventile 166 und 169 in den Bypassleitungen 164 und 165 angeordnet sind. Der Gasmassenfluß der Gase B und C kann somit wie der des Gases A konstant gehalten werden, da das jeweils gerade nicht benötigte Gas über die entsprechende Bypassleitung 164 bzw. 165 zur Pumpe geleitet wird. Die Bypassleitungen 164, 165 weisen denselben Stömungswiderstand auf wie das Gesamtleitungssystem, damit Druckstöße beim Umschalten vermieden werden.

In den Figuren 4 a bis 7 b sind die die Kalottenbeschichtungsstation 1 bildenden Platten 10, 20, 30, 40 sowie die zwischen den Platten angeordneten Dichtscheiben 21, 31 und 41 in Draufsicht und im Schnitt dargestellt.

Die Strömungsrichtung des Frischgases ist durch die durchgezogenen Pfeile und die Strömungsrichtung des Abgases durch die gestrichelten Pfeile dargestellt.

In der Figur 4 a ist die Draufsicht auf die obere Platte 10 dargestellt, die zur Ausbildung von vier Beschichtungskammern 12 a bis 12 d vier Durchgangsbohrungen 14 a bis 14 d aufweist. An der Oberfläche 113 der Platte 10 sind am Rand der Bohrungen 14 a bis 14 d Dichtelemente vorgesehen, auf denen die zu beschichtenden Kalotten 13 aufliegen.

Nach unten schließt sich an die Platte 10 an die Unterseite 112 zunächst die Dichtscheibe 21 mit ihrer Oberfläche 111 an. An der Oberfläche 110 der Dichtscheibe 21 liegt dann die zweite massive Platte 20 an, die in der hier gezeigten Darstellung vier Sackbohrungen 22 aufweist, die zur Vervollständigung der Beschichtungskammern 12 a bis 12 d dienen und deckungsgleich mit den Bohrungen 14 a bis 14 d der Platte 10 angeordnet sind. Im Bodenbereich der Sackbohrungen 22 ist ein Abschnitt 23 des Gasauslaßkanals und ein Abschnitt 24 des Gaseinlaßkanals als Durchgangsbohrung ausgebildet. Der Gaseinlaßkanal-Abschnitt 24 mündet in einen in die Oberfläche 108 eingefrästen Kanal 25, der zu einer zentralen Bohrung 26 führt. Die Kanäle 25, die von der zentralen Bohrung 26 zu den einzelnen Beschichtungskammern 12 a bis 12 d führen, sind sternförmig angeordnet. Die Dicke der Platte 20 ist so zu wählen, daß an der Oberfläche 108 der aus der Bohrung 26 austretenden Gasfluß laminar ist. Die Bestimmung der Dicke aus Gasdaten ist bekannt.

Die zentrale Bohrung 26 mündet in einen an der Oberfläche 109 der Platte 20 eingefrästen Hauptzuführkanal 27, der mit einer Durchgangsbohrung 28 in Verbindung steht. Die Dichtscheibe 21 weist im Bereich der Beschichtungskammern 12 a bis 12 d entsprechende Aussparungen 29 auf.

Die Platte 20 liegt mit ihrer Oberfläche 108 auf der Oberfläche 107 der Dichtscheibe 31 auf, die mit ihrer Oberfläche 106 an der Fläche 105 der dritten massiven Platte 30 anliegt. Die Platte 30 besitzt einen weiteren Abschnitt des gemeinsamen Gaszuführkanals 32, der deckungsgleich mit dem Kanalabschnitt 28 der Platte 20 ausgebildet ist. Der Abschnitt 23 des Gasauslaßkanales mündet in einen Abschnitt 33 in der Platte 30, der mit den sternförmig angeordneten Gasauslaßkanälen 34 in Verbindung steht.

Nach unten schließt sich die Dichtscheibe 41 an, die Aussparungen 45 und 44 aufweist. Mit der Oberfläche 102 liegt die Platte 40 an, die als Abschlußplatte dient und eine zentrale Bohrung 43 für den Gasauslaß und eine Durchgangsbohrung 42 für die Zuführung des Gases aufweist.

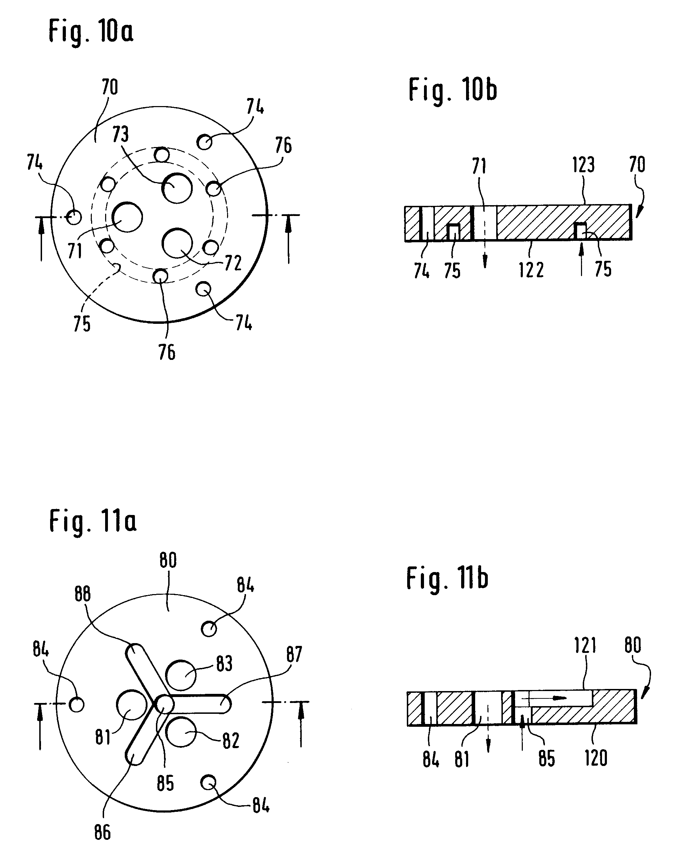

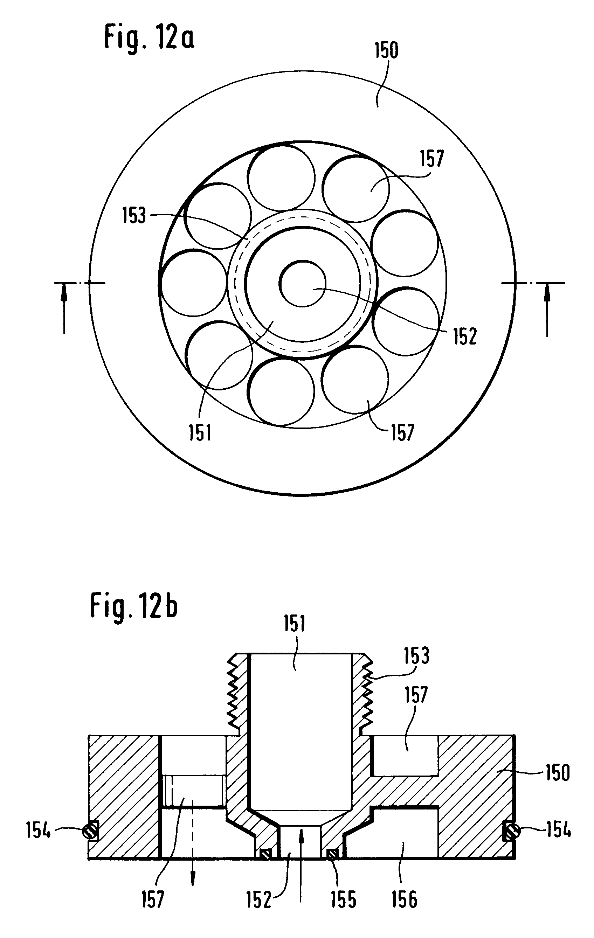

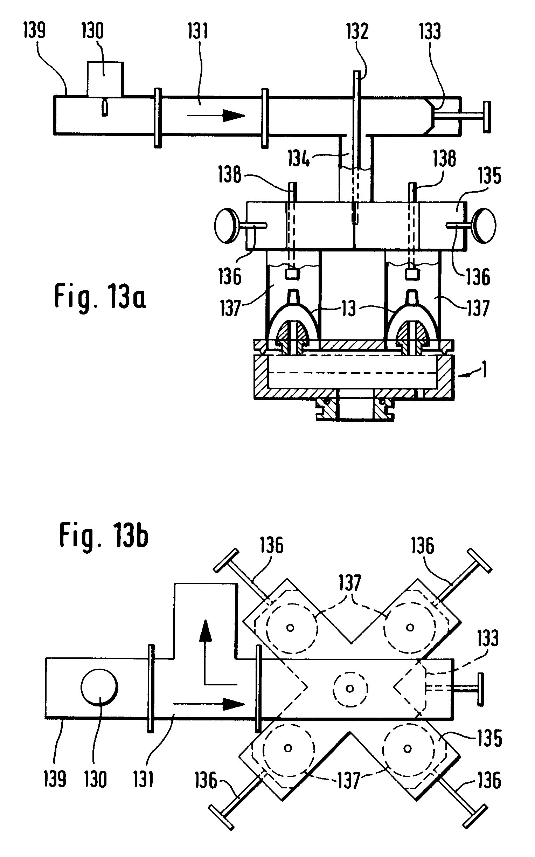

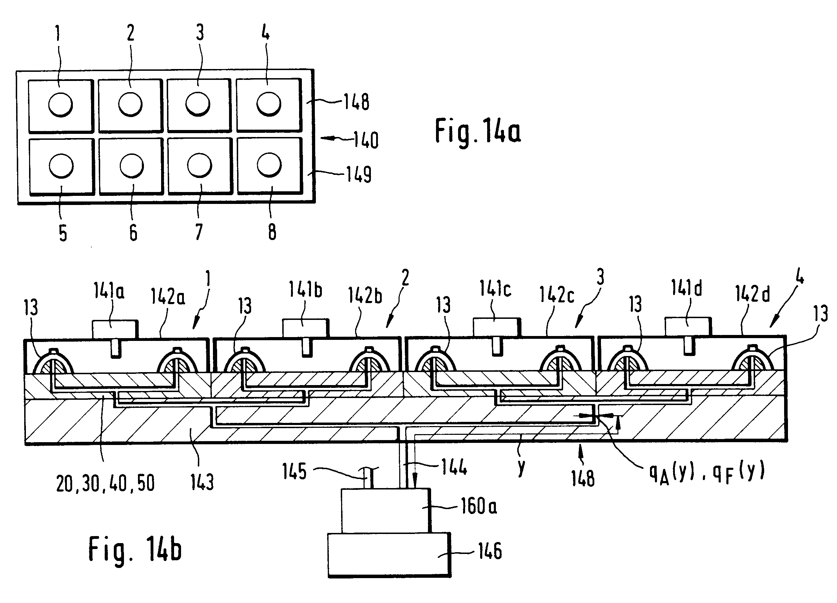

In den Figuren 8 a bis 11 b sind die den Düsenkörper 9 bildenden Düsenplatten in Draufsicht und im Schnitt dargestellt. In der in den Figuren 10 a und 10 b dargestellte Düsenplatte 80 tritt über drei Kanäle 86, 87, 88 das Frischgas strahlenförmig aus dem zentralen Kanal 85 nach außen. Die darüberliegende Düsenplatte 70 verteilt das Frischgas über einen Ringkanal 75 azimutal gleichmäßig und läßt es aus sechs azimutal äquidistant angeordneten Verbindungskanäle 76 aus dem Ringkanal 75 strömen. Diese Platte 70 liegt so auf der Düsenplatte 80, daß die Kanalenden der Düsenplatte 80 genau zwischen zwei Verbindungskanälen 76 der Düsenplatte 70 liegen. So wird gewähreleistet, daß das durch jeden Kanal der Düsenplatte 80 srömende Gas in jeweils zwei gleich große Teilströme aufgeteilt wird. Die jeweiligen Abgaskanäle 81 und 71 werden zentral hochgeführt.

Die Platten 60 und 50, die über der Platte 70 angeordnet sind, sind in entsprechender Weise ausgebildet, wobei der Ringkanal 65 über die Verbindungskanäle 66 mit dem Ringkanal 55 der Platte 50 in Verbindung steht. Das Frischgas strömt schließlich durch die Verbindungskanäle 56 in die Beschichtungskammer ein. Die Anzahl der Verbindungskanäle nimmt von Düsenplatte 80 zu Düsenplatte 70 und von dieser bis zur Düsenplatte 50 jeweils zu.

Die Düsenplatte 50 besitzt einen Gewindefortsatz 53 auf dem der Düsenkörper 51 aufgeschraubt ist, der einen zentralen Kanal 52 zum Entfernen des verbrauchten Reaktionsgases aufweist. Dementsprechend besitzt auch der Gewindefortsatz 53 einen zentralen Kanal, der sich in der darunterliegenden Düsenplatte 60 in den Kanälen 67 und 61, 62 und 63 fortsetzt. Die drei Kanäle 61, 62 und 63 stehen in Verbindung mit den Glasauslaßkanälen 71 - 73 sowie 81 bis 87. Die Platten 50, 60, 70 und 80 werden durch Paßstifte, die nicht dargestellt sind und durch die jeweils drei Bohrungen 54, 64, 74, 84 geführt werden in ihrer Sollposition festgehalten. Da zwischen den Platten 50, 60, 70, 80 nur ein sehr geringes Druckgefälle herrscht, genügt es, die Plattenflächen sehr eben und glatt zu machen, um Leckströme zu vermeiden.

Alternativ zum Gewindefortsatz 53 kann auch ein Konus zur Aufnahme des Verdrängungskörpers dienen, der den Vorteil besitzt, daß der Verdrängungskörper schnell ausgewechselt werden kann. Der Vorteil des Gewindes besteht in der Einstellmöglichkeit des Verdrängungskörpers bezüglich der zu beschichtenden Kalottenfläche.

Wird das Frischgas durch den Verdrängungskörper eingeleitet, dann ist der Düsenkörper 150 wie in den Figuren 11a und 11b zu sehen ist, einteilig aufgebaut. Durch den Einlaßkanal 152 und den Kanal 151, der in dem zentralen Kanal des Verdrängungkörpers (nicht dargestellt) einmündet, wird das Frischgas eingeleitet. Durch die Verbindungsbohrung 157, die in dem Ringkanal 156 münden, wird das verbrauchte Gas abgeleitet. Der Düsenkörper 150 weist Dichtelemente 154 und 155 auf, damit eine Vermischung von Frischgas und verbrauchtem Gas verhindert wird.

In der Figur 13 a und in der Figur 13 b ist eine Kalottenbeschichtungsstation 1 mit der dazugehörigen Mikrowelleneinrichtung dargestellt. Die Mikrowellenversorgung weist ein Hohlleiterkreuz 135 auf, aus dem über vier Metallrohre 137, die mit den Metallkoppelstiften 138 einen koaxialen Mikrowellenleiter bilden, die Feldenergie zu den zu beschichtenden Kalotten 13 geleitet wird. Die vier Rechteckhohlleiterarme des Hohlleiterkreuzes 135 sind durch Kurzschlußschieber 136 abgeschlossen. Über den zu beschichtenden Kalotten 13 sind Metallkoppelstifte 138 vorgesehen. Zwischen der Kreuzmitte und den Kurzschlußschiebern 136 ist je ein Übergang vom Rechteckhohlleiter auf Koaxialleiter vorgesehen. Der Metallkoppelstift 132 ist die Innenleiter der Koaxialleitung 134. Seine Eintauchtiefe in den zugehörigen Außenleiter und die Stellung der Kurzschlußschieber bestimmen die Größe der reflektierten Mikrowellenleistung, die zu minimieren ist. In dem Hohlleiter 139 ist das gemeinsame Magnetron 130 angeordnet. In der Einwegleitung 131 wird die reflektierte Leistung absorbiert.

In der Figur 14 a ist eine Beschichtungsanlage 140 in Draufsicht dargestellt, die aus insgesamt acht Kalottenbeschichtungsstationen 1 bis 8 besteht, die zu zwei Gruppen 148 und 149 zusammengefaßt sind.

In der Figur 14 b ist die Gruppe 148 von Kalottenbeschichtungsstationen 1 bis 4 dargestellt. Jede Kalottenbeschichtungsstation besitzt einen Resonatorkasten 142 a, b, c, d, in dem mittig jeweils ein Magnetron 141 a, b, c, d, angeordnet ist. Diese Magnetrons 141 a, b, c, d, sind an Impulsgeneratoren angeschlossen, die nicht dargestellt sind. Die einzelnen Kalottenbeschichtungsstationen 1 bis 4 bestehen aus jeweils vier Platten 20, 30, 40, 50, wie es in den Figuren 2 und 4 a bis 7 b dargestellt ist.

Die Kalottenbeschichtungsstationen 1 bis 4 sind nebeneinander auf einer Verteilerplatte 143 angeordnet, die Versorgungskanäle 144 und nicht dargestellte Gasableitkanäle aufweist. Auch die Verteilerplatte 143 kann aus mehreren Platten aufgebaut sein, in die die Kanäle durch Bohren und Fräsen eingebracht sind. Der Gaserzeuger 146 mit einer Gasverteilungseinrichtung 160a ist dazu ausgebildet, gleichzeitig an die eine Gruppe 148 die Gasarten A und B und an die Gruppe 149 die Gasarten A und C zu liefern. Hierzu sind die Gasversorgungsleitungen 144 und 145 vorgesehen, wobei die Versorgungsleitung 145 zur Gruppe 149 führt. Bei der Herstellung der Interferenzschichtsysteme werden die Gase B und C in die jeweils andere Kalottenbeschichtungsgruppe umgeleitet, wenn die entsprechenden Schichten gerade aufgebracht sind. Dauert die Herstellung der Schichten, für die die Gase B und C benötigt werden, unterschiedlich lange, dann wird das Gas, das gerade nicht benötigt wird in die Bypassleitung (nicht dargestellt) umgeleitet. In der Kalottenbeschichtungsgruppe, in der gerade nicht beschichtet wird, läßt man zweckmäßigerweise ein Sauerstoffplasma brennen, um zu verhindern, daß die Kalotten abkühlen. Anstelle der Ausbildung von Gruppen können auch alle Kalottenbeschichtungsstationen 1 - 8 gleichzeitig mit gleichen Gasen beschichtet werden, wobei das jeweils nicht genutzte Gas in einer - ähnlich der in Figur 2 gezeigten - Gasverteilungseinrichtung 160 über eine Bypassleitung abgeleitet wird.

### BEZUGSZEICHENLISTE

- 1-8: Kalottenbeschichtungsstation
- 9: Düsenkörper
- 10: Grundplatte
- 12 a, b, c: Beschichtungskammer
- 13: kalottenförmiges Substrat
- 14: Durchgangsbohrung
- 20: Platte
- 21: Dichtscheibe
- 22: Sackbohrung
- 23: Abschnitt Auslaßkanal
- 24 bis 26: Abschnitte Gaseinlaßkanal
- 27, 28: Haupteinlaßkanal
- 29: Aussparung
- 30: Platte
- 31: Dichtscheibe
- 32: Haupteinlaßkanal
- 33, 34: Abschnitte Auslaßkanal
- 35, 36: Aussparung
- 40: Platte
- 41: Dichtscheibe
- 42: Abschnitt Haupteinlaßkanal
- 43: Abschnitt Hauptauslaßkanal
- 44, 45: Aussparung
- 50: Düsenplatte
- 51: Verdrängungskörper
- 52: Zentraler Kanal
- 53: Gewindefortsatz
- 54: Stiftbohrung
- 55: Ringkanal
- 56: Verbindungskanal
- 60: Düsenplatte
- 61 bis 63: Auslaßkanal
- 64: Stiftbohrung
- 65: Ringkanal
- 66: Verbindungskanal
- 67: Verteilerkanal
- 70: Düsenplatte
- 71 bis 73: Auslaßkanal
- 74: Stiftbohrung
- 75: Ringkanal
- 76: Verbindungskanal
- 80: Düsenplatte
- 81 bis 83: Auslaßkanal
- 84: Stiftbohrung
- 85 bis 88: Einlaßkanal
- 89:
- 90: Vakuumpumpe
- 91: Gasleitung
- 92: Gasleitung
- 93: Gasleitung
- 95: symmetrische Gasleitungssystem
- 100 bis 113: Oberflächen
- 120 bis 126: Oberflächen
- 130: Magnetron
- 131: Einwegleitung
- 132: Koppelstift
- 133: Kurzschlußschieber
- 134: Koaxialzwischenstück
- 135: Hohlleiterkreuz
- 136: Kurzschlußschieber
- 137: Metallrohr
- 138: Koppelstift
- 139: Rechteckhohlleiter
- 140: Beschichtungsanlage
- 141 a, b, c, d,: Magnetron
- 142: Resonatorkasten
- 143: Verteilerplatte
- 144: Versorgungskanal
- 145: Versorgungskanal
- 146: Gaserzeuger
- 148: Kalottenbeschichtungsgruppe
- 149: Kalottenbeschichtungsgruppe
- 150: Düsenplatte
- 151: Zentraler Kanal
- 152: Zentraler Kanal
- 153: Gewindefortsatz
- 154, 155: Dichteelemente
- 156: Ringkanal
- 157: Verbindungsbohrung
- 160: Gasverteilungseinrichtung
- 160a: Gasverteilungseinrichtung
- 161: Gasleitung
- 162: Gasleitung
- 163: Gasleitung
- 164: Bypassleitung
- 165: Bypassleitung
- 166: Ventile
- 167: Ventile
- 168: Ventile
- 169: Ventile
- 170: Gasleitung
- 171: Gasleitung
- 172: Gasleitung
- 175: symmetrische Gasleitungssysteme
- 180: Rezipienteil

## Patentansprüche

1. Vorrichtung zum Beschichten der Innenfläche von kalottenförmigen Substraten mit einem dielektrischen Schichtsystem, insbesondere von Reflektoren mit einer Kaltlichtspiegelbeschichtung, mit einer Beschichtungskammer, die durch das kalottenförmige Substrat und ein mit diesem an den Ränden zusammengesetztes und gasdicht verbundenes Rezipiententeil gebildet ist, in das ein Gaseinlaßkanal und ein Gasauslaßkanal münden und das einen, einen oder mehrere Kanäle aufweisenden Verdrängungskörper zur Begrenzung der zu reagierenden Gasschicht aufweist, sowie mit Mitteln zur Anregung einer Plasmazone in der zu reagierenden Gasschicht, dadurch gekennzeichnet,
daß mindestens zwei Beschichtungskammern (12 a, 12 b, 12 c, 12 d) unter Ausbildung einer Kalottenbeschichtungsstation (1) nebeneinander angeordnet sind, die an einen für alle Beschichtungskammern (12 a - d) gemeinsamen Gaserzeuger (146) und an eine gemeinsame Vakuumpumpe (90) mittels Gasleitungen angeschlossen ist, wobei die Gasleitungen für die Gaszufuhr jeweils ein symmetrisches Gasleitungssystem (175, 95) bilden, wobei die Querschnittsfläche Q_{A}(x) und die Querschnittsform Q_{F}(x) der Gasleitungen in Abhängigkeit von der Entfernung x vom Gaserzeuger (146) bzw. von der Vakuumpumpe (90) im wesentlichen gleich ist.

2. Vorrichtung nach Anspruch 1, dadurch gekennzeichnet, daß die Gasleitungssysteme (95, 175) aus Präzisionsrohren (91 - 93, 170 - 172) aufgebaut sind.

3. Vorrichtung nach Anspruch 1, dadurch gekennzeichnet, daß die Rezipiententeile (180) als Ausnehmungen (14, 22) in mindestens einer gemeinsamen massiven Platte (10 - 40) ausgebildet sind, in die die symmetrischen Gasleitungssysteme (95, 175) als Gaskanäle (24 - 28, 32, 42; 23, 33, 34, 43) eingebracht sind.

4. Vorrichtung nach Anspruch 1 oder 3, dadurch gekennzeichnet, daß die Beschichtungskammern (12 a bis 12 d) auf einem Kreis angeordnet sind, zu dem die Gaseinlaßkanäle (24, 25, 26) und die Gasauslaßkanäle (23, 33, 34) vom Zentrum der Kalottenbeschichtungsstation (1) sternförmig hinführen, wobei das Zentrum jeweils mit einem Haupteinlaßkanal (27, 28, 32, 42) und einem Hauptauslaßkanal (43) verbunden ist.

5. Vorrichtung nach einem der Ansprüche 1 oder 2, dadurch gekennzeichnet, daß mindestens zwei Platten (10, 20, 30, 40) übereinandergelegt sind, wobei die Gaseinlaßkanäle (24 bis 48, 32, 42) und die Gasauslaßkanäle (23, 33, 34, 43) ausschließlich durch Bohren und/oder Fräsen in den Oberflächen der Platten hergestellt sind.

6. Vorrichtung nach einem der Ansprüche 3 bis 5, dadurch gekennzeichnet, daß zwischen den Platten (10, 20, 30, 40) Dichtungselemente angeordnet sind.

7. Vorrichtung nach Anspruch 5, dadurch gekennzeichnet, daß die Dichtungselemente Dichtungsscheiben (21, 31, 41) aus Silikongummi oder Teflon gefertigt sind, die zumindest teilweise an die in den Platten (10, 20, 30, 40) eingebrachten Durchgangsbohrungen angepaßte Aussparungen (44, 45) aufweisen.

8. Vorrichtung nach einem der Ansprüche 3 bis 5, dadurch gekennzeichnet, daß jeweils mindestens eine der berührenden Oberflächen (101, 104, 105, 108, 109, 112) der Platten (10, 20, 30, 40) mit einer Elastomerschicht versehen ist.

9. Vorrichtung nach einem der Ansprüche 3 bis 8, dadurch gekennzeichnet daß die Platten (10, 20, 30, 40) aus Metall oder Kunststoff bestehen.

10. Vorrichtung nach einem der Ansprüche 3 bis 9, dadurch gekennzeichnet, daß die Platten (10, 20, 30, 40) mit einer gegen das Gas resistenten Beschichtung versehen sind.

11. Vorrichtung nach einem der Ansprüche 1 bis 10, dadurch gekennzeichnet, daß der Verdrängungskörper (51) auf einem Düsenkörper (9) in axialer Richtung verstellbar angeordnet ist.

12. Vorrichtung nach Anspruch 11, dadurch gekennzeichnet, daß der Düsenkörper (9) sandwichartig aus mindestens zwei Düsenplatten (50, 60, 70, 80) aufgebaut ist, die Kanäle (55, 56, 65, 66, 75, 76) zur azimutalen Gasführung aufweisen.

13. Vorrichtung nach Anspruch 12, dadurch gekennzeichnet, daß in jeder Düsenplatte (50, 60, 70, 80) ein Ringkanal (55, 65, 75) vorgesehen ist, der mit dem Ringkanal (55, 65, 75) der benachbarten Düsenplatte über Verbindungskanäle (56, 66, 76) in Verbindung steht, wobei die Verbindungskanäle benachbarter Düsenplatten versetzt zueinander angeordnet sind.

14. Vorrichtung nach einem der Ansprüche 11 oder 12, dadurch gekennzeichnet, daß die Anzahl der Verbindungskanäle (56, 66, 76) von Düsenplatte zu Düsenplatte in Richtung zum kalottenförmigen Substrat (13) zunimmt.

15. Vorrichtung nach einem der Ansprüche 1 bis 14, dadurch gekennzeichnet, daß eine Gasverteilungseinrichtung (160) zwischen dem symmetrischen Gasleitungssystem (175) und dem Gaserzeuger (146) angeordnet ist.

16. Vorrichtung nach einem der Ansprüche 1 bis 15, dadurch gekennzeichnet, daß die Mittel zur Anregung einer Plasmazone aus einem der Kalottenbeschichtungsstationen (1 bis 8) zugeordneten gemeinsamen Mikrowelleneinrichtung bestehen, die ein Magnetron (130, 141) mit einem Impulsgeber umfaßt.

17. Vorrichtung nach Anspruch 16, dadurch gekennzeichnet, daß über den kalottenförmigen Substraten (13) ein auf die Kalottenbeschichtungsstationen (1 bis 8) absenkbarer Resonatorkasten (142) mit mittig sitzendem Magnetron (141) angeordnet ist.

18. Vorrichtung nach Anspruch 16, dadurch gekennzeichnet, daß über den kalottenförmigen Substraten (13) ein auf die Kalottenbeschichtungsstation (1) absenkbares Hohlleiterkreuz (135) mit Metallrohren (137) angeordnet ist, das über Verbindungshohlleiter (131, 134, 139) an das Magnetron (130) angeschlossen ist.

19. Vorrichtung nach einem der Ansprüche 1 bis 15, dadurch gekennzeichnet, daß die Mittel zur Anregung einer Plasmazone aus einer jeder Beschichtungskammer (12 a - d) zugeordneten Mikrowelleneinrichtung besteht, die jeweils ein Magnetron mit einem Impulsgeber umfaßt.

20. Anlage zum Beschichten der Innenfläche von kalottenförmigen Substraten, dadurch gekennzeichnet,
daß mindestens zwei Kalottenbeschichtungsstationen (1 bis 8) gemäß einem der Ansprüche 1 bis 18 an einen gemeinsamen Gaserzeuger (146) bzw. gemeinsame Vakuumpumpe (90) mittels Gasleitungen angeschlossen sind, wobei die Gasleitungen ebenfalls ein symmetrisches Gasleitungssystem bilden, wobei die Querschnittsfläche q_{A}(y) und die Querschnittsform q_{F}(y) der Gasleitungen in Abhängigkeit der Entfernung y vom Gaserzeuger bzw. von der Vakuumpumpe im wesentlichen gleich ist.

21. Anlage nach Anspuch 20, dadurch gekennzeichnet, daß die Kalottenbeschichtungsstationen (1 bis 8) auf einer ein- oder mehrteiligen massiven Verteilerplatte (143) nebeneinander angeordnet sind, in die die symmetrischen Gasleitungssysteme als Versorgungskanäle (144, 145) und Absaugkanäle eingebracht sind.

22. Anlage nach Anspruch 20 oder 21, dadurch gekennzeichnet, daß die Versorgungskanäle (144, 145) und die Absaugkanäle ausschließlich durch Bohren und/oder Fräsen in der Oberfläche der Verteilerplatte (143) hergestellt sind.

23. Anlage nach einem der Ansprüche 20 bis 22, dadurch gekennzeichnet, daß die Kalottenbeschichtungsstationen (1 bis 8) zu zwei Gruppen (148, 149) zusammengefaßt sind, wobei jede Gruppe (148, 149) über eigene Versorgungskanäle (144, 145) mit dem Gaserzeuger (146) verbunden ist, der zur Versorgung der beiden Kalottenbeschichtungsgruppen (148, 149) mit unterschiedlichen Gasgemischen ausgebildet ist.

24. Anlage nach einem der Ansprüche 20 bis 23, dadurch gekennzeichnet, daß in den Versorgungsleitungen (144, 145) eine Gasverteilungseinrichtung (160a) angeordnet ist, so daß die Kalottenbeschichtungsgruppen (148, 149) abwechselnd mit den Gasgemischen beaufschlagbar sind.

## Claims

1. Device for coating the inner surface of dome-shaped substrates with a dielectric laminated system, in particular of reflectors with a cold-light mirror coating, having a coating chamber formed by the dome-shaped substrate and a recipient part, which is placed together with and connected in a gastight manner to the substrate at the edges and into which a gas inlet channel and a gas outlet channel open and which has a displacement body with one or more channels for delimiting the gas layer for reaction, as well as having means of exciting a plasma zone in the gas layer for reaction, characterized in that
at least two coating chambers (12a, 12b, 12c, 12d) are disposed alongside one another to form a dome coating station (1), which is connected to a gas producer (146) common to all coating chambers (12a - 12d) and to a common vacuum pump (90) by means of gas lines, the gas lines for the gas supply in each case forming a symmetrical gas line system (175, 95), the cross-sectional area Q_{A}(x) and the cross-sectional shape Q_{F}(x) of the gas lines being substantially identical as a function of the distance x from the gas producer (146) and/or from the vacuum pump (90).

2. Device according to claim 1, characterized in that the gas line systems (95, 175) are assembled from precision pipes (91 - 93, 170 - 172).

3. Device according to claim 1, characterized in that the recipient parts (180) take the form of recesses (14, 22) in at least one common solid plate (10 - 40), into which the symmetrical gas line systems (95, 175) are introduced as gas channels (24 - 28, 32, 42; 23, 33, 34, 43).

4. Device according to claim 1 or 3, characterized in that the coating chambers (12a to 12d) are disposed on a circle, to which the gas inlet channels (24, 25, 26) and the gas outlet channels (23, 33, 34) extend radially from the centre of the dome coating station (1), the centre being in each case connected to a main inlet channel (27, 28, 32, 42) and to a main outlet channel (43).

5. Device according to one of claims 1 or 2, characterized in that at least two plates (10, 20, 30, 40) are placed one above the other, the gas inlet channels (24 to 48, 32, 42) and the gas outlet channels (23, 33, 34, 43) being manufactured exclusively by drilling and/or cutting in the surfaces of the plates.

6. Device according to one of claims 3 to 5, characterized in that sealing elements are disposed between the plates (10, 20, 30, 40).

7. Device according to claim 5, characterized in that the sealing elements are sealing disks (21, 31, 41) made of silicone rubber or Teflon, which have recesses (44, 45) at least partially adapted to the through bores introduced in the plates (10, 20, 30, 40).

8. Device according to one of claims 3 to 5, characterized in that in each case at least one of the contact surfaces (101, 104, 105, 108, 109, 112) of the plates (10, 20, 30, 40) is provided with an elastomer layer.

9. Device according to one of claims 3 to 8, characterized in that the plates (10, 20, 30, 40) are made of metal or plastic material.

10. Device according to one of claims 3 to 9, characterized in that the plates (10, 20, 30, 40) are provided with a coating resistant to the gas.

11. Device according to one of claims 1 to 10, characterized in that the displacement body (51) is disposed in an axially adjustable manner on a nozzle body (9).

12. Device according to claim 11, characterized in that the nozzle body (9) is of a sandwich-style construction comprising at least two nozzle plates (50, 60, 70, 80) which have channels (55, 56, 65, 66, 75, 76) for azimuthal gas feeding.

13. Device according to claim 12, characterized in that provided in each nozzle plate (50, 60, 70, 80) is an annular channel (55, 65, 75) which communicates with the annular channel (55, 65, 75) of the adjacent nozzle plate via connecting channels (56, 66, 76), the connecting channels of adjacent nozzle plates being arranged offset relative to one another.

14. Device according to one of claims 11 or 12, characterized in that the number of connecting channels (56, 66, 76) increases from nozzle plate to nozzle plate in the direction of the dome-shaped substrate (13).

15. Device according to one of claims 1 to 14, characterized in that a gas distributing device (160) is disposed between the symmetrical gas line system (175) and the gas producer (146).

16. Device according to one of claims 1 to 15, characterized in that the means of exciting a plasma zone comprise a common microwave device, which is associated with the dome coating stations (1 to 8) and includes a magnetron (130, 141) with a pulse generator.

17. Device according to claim 16, characterized in that a resonator box (142) with a centrally seated magnetron (141) is disposed above the dome-shaped substrates (13) and may be lowered onto the dome coating stations (1 to 8).

18. Device according to claim 16, characterized in that a waveguide cross (135) with metal pipes (137), which may be lowered onto the dome coating station (1), is disposed above the dome-shaped substrates (13) and is connected by connecting waveguides (131, 134, 139) to the magnetron (130).

19. Device according to one of claims 1 to 15, characterized in that the means of exciting a plasma zone comprises a microwave device, which is associated with each coating chamber (12a - 12d) and in each case includes a magnetron with a pulse generator.

20. Installation for coating the inner surface of dome-shaped substrates, characterized in that
at least two dome coating stations (1 to 8) according to one of claims 1 to 18 are connected to a common gas producer (146) and/or common vacuum pump (90) by means of gas lines, the gas lines likewise forming a symmetrical gas line system, the cross-sectional area q_{A}(y) and the cross-sectional shape q_{F}(y) of the gas lines being substantially identical as a function of the distance y from the gas producer and/or from the vacuum pump.

21. Installation according to claim 20, characterized in that the dome coating stations (1 to 8) are disposed alongside one another on a single- or multi-part solid distributor plate (143), into which the symmetrical gas line systems are introduced as supply channels (144, 145) and extraction channels.

22. Installation according to claim 20 or 21, characterized in that the supply channels (144, 145) and the extraction channels are manufactured exclusively by drilling and/or cutting in the surface of the distributor plate (143).

23. Installation according to one of claims 20 to 22, characterized in that the dome coating stations (1 to 8) are combined into two groups (148, 149), each group (148, 149) being connected by its own supply channels (144, 145) to the gas producer (146), which is designed so as to supply the two dome coating groups (148, 149) with different gas mixtures.

24. Installation according to one of claims 20 to 23, characterized in that a gas distributing device (160a) is disposed in the supply lines (144, 145) so that the dome coating groups (148, 149) may be alternately acted upon by the gas mixtures.

## Revendications

1. Dispositif de revêtement de la surface intérieure de substrats en forme de calotte à l'aide d'un système de couches diélectriques, en particulier de réflecteurs, à l'aide d'un revêtement de réflexion de lumière froide, comprenant une chambre de revêtement qui est formée par le substrat en forme de calotte et une partie de récipient assemblée et réunie de façon étanche aux gaz avec ledit substrat sur les bords, partie de récipient dans laquelle débouche un canal d'entrée de gaz et un canal de sortie de gaz et qui comprend un corps de déplacement présentant un ou plusieurs canaux en vue de la délimitation de la couche de gaz de réaction, ainsi que des moyens pour exciter une zone de plasma dans la couche de gaz de réaction, caractérisé par le fait qu'au moins deux chambres de revêtement (12a, 12b, 12c, 12d) sont disposées côte à côte en formant un poste de revêtement de calottes (1) qui est relié a un générateur de gaz (146) commun pour toutes les chambres de revêtement (12a-d) et à une pompe à vide (90) commune au moyen de conduites de gaz, les conduites de gaz formant, pour l'arrivée de gaz, chaque fois un système symétrique de conduites de gaz (175, 95), la section Q_{A} (x) et le profil Q_{F} (x) des conduites de gaz, en relation avec la distance x du générateur de gaz (146) et de la pompe à vide (90), étant sensiblement égaux.

2. Dispositif suivant revendication 1, caractérisé par le fait que les systèmes de conduites de gaz (95, 175) sont formés de tubes de précision (91-93, 170-172).

3. Dispositif suivant revendication 1, caractérisé par le fait que les parties de récipient (180) sont réalisés sous forme d'évidements (14, 22) dans au moins une plaque massive commune (10-40) dans laquelle les systèmes symétriques de conduites de gaz (95, 175) sont ménagés sous forme de canaux de gaz (24-28, 32, 42; 23, 33, 34, 43).

4. Dispositif suivant revendication 1 ou 3, caractérisé par le fait que les chambres de revêtement (12a à 12d) sont disposées sur un cercle vers lequel les canaux d'entrée de gaz (24, 25, 26) et les canaux de sortie de gaz (23, 33, 34) mènent en étoile depuis le centre du poste de revêtement de calottes (1), le centre étant relié respectivement à un canal d'entrée principal (27, 28, 32, 42) et à un canal de sortie principal (43).

5. Dispositif suivant l'une des revendications 1 ou 2, caractérisé par le fait qu'au moins deux plaques (10, 20, 30, 40) sont superposées, les canaux d'entrée de gaz (24 à 48, 32, 42) et les canaux de sortie de gaz (23, 33, 34, 43) étant réalisés exclusivement par perçage et/ou fraisage dans les surfaces des plaques.

6. Dispositif suivant l'une des revendications 3 à 5, caractérisé par le fait que des éléments d'étanchéité sont disposés entre les plaques (10, 20, 30, 40).

7. Dispositif suivant la revendication 6, caractérisé par le fait que les éléments d'étanchéité sont constitués par des lames d'étanchéité (21, 31, 41) en caoutchouc de silicone ou Téflon, qui présentent des échancrures (44, 45) adaptées au moins partiellement aux trous de passage ménagés dans les plaques (10, 20, 30, 40).

8. Dispositif suivant l'une des revendications 3 à 5, caractérisé par le fait qu'au moins l'une des surfaces de contact (101, 104, 105, 108, 109, 112) des plaques (10, 20, 30, 40) est munie d'une couche d'élastomère.

9. Dispositif suivant l'une des revendications 3 à 8, caractérisé par le fait que les plaques (10, 20, 30, 40) sont en métal ou en matière plastique.

10. Dispositif suivant l'une des revendications 3 à 9, caractérisé par le fait que les plaques (10, 20, 30, 40) sont munies d'un revêtement résistant au gaz.

11. Dispositif suivant l'une des revendications 1 à 10, caractérisé par le fait que le corps de déplacement (51) est disposé de façon réglable en direction axiale sur un corps de tuyère (9).

12. Dispositif suivant revendication 11, caractérisé par le fait que le corps de tuyère (9) est réalisé en sandwich à partir d'au moins deux plaques de tuyère (50, 60, 70, 80) qui présentent des canaux (55, 56, 65, 66, 75, 76) pour la conduite de gaz azimutale.

13. Dispositif suivant revendication 12, caractérisé par le fait que dans chaque plaque de tuyère (50, 60, 70, 80) est prévu un canal annulaire (55, 65, 75) qui se trouve en communication avec le canal annulaire (55, 65, 75) de la plaque de tuyère voisine en passant par des canaux de liaison (56, 66, 76), les canaux de liaison des plaques de tuyère voisines étant décalés les uns par rapport aux autres.

14. Dispositif suivant l'une des revendications 11 ou 12, caractérisé par le fait que le nombre des canaux de liaison (56, 66, 76) diminue d'une plaque de tuyère à la suivante en direction du substrat (13) en forme de calotte.

15. Dispositif suivant l'une des revendications 1 à 14, caractérisé par le fait qu'un dispositif de distribution de gaz (160) est disposé entre le système symétrique de conduites de gaz (175) et le générateur de gaz (146).

16. Dispositif suivant l'une des revendications 1 à 15, caractérisé par le fait que les moyens pour l'excitation d'une zone de plasma se composent d'un dispositif micro-ondes commun associé aux postes de revêtement de calottes (1 à 8), ce dispositif comprenant un magnétron (130, 141) avec un générateur d'impulsions.

17. Dispositif suivant la revendication 16, caractérisé par le fait qu'un caisson résonateur (142) avec magnétron central (141) est disposé au-dessus des substrats (13) en forme de calotte de manière à pouvoir être abaissé sur les postes de revêtement de calottes (1 à 8).

18. Dispositif suivant la revendication 16, caractérisé par le fait qu'une croix de guide d'ondes (135) avec tubes métalliques (137) est disposée au-dessus des substrats (13) en forme de calotte de manière à pouvoir être abaissée sur le poste de revêtement de calottes (11), cette croix étant raccordée par des guides d'ondes de liaison (131, 134, 139) au magnétron (130).

19. Dispositif suivant l'une des revendications 1 à 15, caractérisé par le fait que les moyens pour l'excitation d'une zone de plasma comprennent un dispositif micro-ondes associé à chaque chambre de revêtement (12a-d), ce dispositif comprenant respectivement un magnétron avec un générateur d'impulsions.

20. Installation pour le revêtement de la face intérieure de substrats en forme de calotte, caractérisée par le fait qu'au moins deux postes de revêtement de calottes (1 à 8) suivant l'une des revendications 1 à 8 sont raccordés à un générateur de gaz commun (146) et à une pompe à vide commune (90) à l'aide de conduites de gaz, les conduites de gaz formant également un système symétrique de conduites de gaz, la section q_{A} (y) et le profil q_{F} (y) des conduites de gaz étant essentiellement égales en relation avec la distance y du générateur de gaz et de la pompe à vide.

21. Installation suivant la revendication 20, caractérisée par le fait que les postes de revêtement de calottes (1 à 8) sont disposés côte à côte sur une plaque de distributeur (143) massive, en une ou plusieurs parties, dans laquelle les systèmes symétriques de conduites de gaz sont ménagés sous forme de canaux d'alimentation (144, 145) et de canaux d'extraction.

22. Installation suivant la revendication 20 ou 21, caractérisée par le fait que les canaux d'alimentation (144, 145) et les canaux d'extraction sont pratiqués exclusivement par perçage et/ou fraisage dans la surface de la plaque de distributeur (143).

23. Installation suivant l'une des revendications 20 à 22, caractérisée par le fait que les postes de revêtement de calottes (1 à 8) sont regroupés en deux groupes (148, 149), chaque groupe étant relié par des canaux de liaison (144, 145) à un générateur de gaz (146) qui est conçu pour l'alimentation des deux groupes de revêtement de calottes (148, 149) avec des mélanges de gaz différents.

24. Installation suivant l'une des revendications 20 à 23, caractérisée par le fait qu'un dispositif de distribution de gaz (160a) est disposé dans les conduites d'alimentation (144, 145) de manière que les groupes de revêtement de calottes (148, 149) puissent être alimentés en alternance avec les mélanges de gaz.
